# EUROPEAN PATENT SPECIFICATION

(11) **EP 0 620 259 B1**
(45) Date of publication and mention of the grant of the patent: **25.06.2003**
(21) Application number: 94105789.5
(22) Date of filing: 14.04.1994
(51) Int. Cl.: C09J 163/00, C09J 167/00, C08G 59/68, C08L 63/00, C08L 67/00

(54) **Epoxy/polyester hot melt compositions**
Epoxydharz und Polyesterharz enthaltende heissschmelzbare Zusammensetzungen
Compositions thermofusible contenant une résine époxyde et un polyester

(30) Priority: 15.04.1993 US 47862
(43) Date of publication of application: 19.10.1994
(73) Proprietor: MINNESOTA MINING AND MANUFACTURING COMPANY, St. Paul, Minnesota 55133-3427 (US)
(72) Inventor: George, Clayton A., c/o Minnesota Mining and, St. Paul, Minnesota 55133-3427 (US); Stobbie, Charles W., IV, c/o Minnesota Mining and, St. Paul, Minnesota 55133-3427 (US)
(74) Representative: VOSSIUS & PARTNER

(56) References cited:
- EP-A- 0 118 044
- EP-A- 0 321 407
- WO-A-92/20754
- FR-A- 2 393 043
- US-A- 4 059 715
- US-A- 4 560 579
- DATABASE WPI Derwent Publications Ltd., London, GB; AN 93-269986(34) & JP-A-5 186 755 (YOKOHAMA RUBBER KK) 27 July 1993
- DATABASE WPI Derwent Publications Ltd., London, GB; AN 86-003077(01) & JP-A-60 228 527 (MITSUBISHI PAPER MILL) 13 November 1985

## Description

In general, this invention relates to epoxy/polyester hot melt compositions and, more particularly, to such compositions which, upon exposure to radiation, cure to provide a high strength adhesive having good green strength build-up.

Many adhesive and coating compositions are known, particular advantages and disadvantages being associated with each. For example, polyester based moisture curable hot melt compositions are a solid at room temperature but upon heating melt to a viscous liquid that can be readily applied to a substrate. The compositions react with ambient moisture to provide a cured, crosslinked thermoset adhesive. Because of their moisture sensitivity, special packaging is required and care must be taken during processing to avoid the accumulation of uncured residue that could react with moisture in the manufacturing equipment. Furthermore, because of their moisture sensitivity, these materials cannot be readily provided in film form and work best when applied to moisture permeable (e.g. plastic and wood) substrates.

Thermally cured hot melt compositions have a limited pot life because application in the melted state also initiates the curing reaction. These compositions typically require elaborate clamping mechanisms to secure the bonded parts during the elevated temperature curing cycle and are not particularly favored for use with heat sensitive substrates.

However, hot melt compositions are desirable because they are easily used and some formulations do not require clamps. Moreover, the compositions are free from solvents.

Many well known adhesive and coating compositions are based on epoxies. Some cure at room temperature but these are typically two part systems that require separate inventories of the individual components which can only be mixed shortly before use. Such compositions tend to have relatively short pot lives, are not generally provided in film form, and frequently require clamps to hold the bonded parts in place until the compositions cure. Epoxy adhesives are sought after, however, because of their excellent ultimate strength and heat resistance.

Consequently, it would be desirable to have a single adhesive composition that is free from as many of the foregoing disabilities as possible. That is, there would be a considerable demand for an easily applied, one part adhesive that is not sensitive to moisture and which cures quickly to a high strength structural adhesive but which also has good green strength build-up so that clamps are not needed to secure the bonded components. Such compositions would be in even greater demand if they were free from solvents, especially if they could be tailored to provide specific physical properties for particular situations.

Epoxy-based adhesive or coating compositions are disclosed in various references. Exemplary of these is US-A-4,622,349 which discloses photocopolymerizable compositions comprising an epoxy having two or more epoxy groups, a hydroxyl substituted cycloaliphatic monoepoxide, an active hydrogen organic compound (preferably an organic polyol), and a photoinitiator. The examples describe applying the compositions to steel panels with a wire-wound rod.

US-A-4,812,488 is directed to photocopolymerizable compositions comprising an active hydrogen organic compound, a photoinitiator, and a substituted cycloaliphatic monoepoxide reactive diluent. The examples describe applying the compositions to steel panels with a wire-wound rod. Viscosity data are disclosed in Table I. Reportedly, the compositions provide excellent pressure sensitive and heat-activated adhesive coatings after having been applied to a suitable substrate and cured.

US-A-4,920,182 discloses adhesives and coating agents that contain an epoxy resin having at least two epoxy groups, an initiator, and a flexible polyester. Reportedly, the viscosity of the polyester is, as a rule, less than 2000 mPas at 80°C.

International Patent Application No. US92/01974 discloses a pressure sensitive adhesive that comprises an epoxide resin, a polymeric film former (e.g., polyacrylates, polymethacrylates, phenoxy resins, polysulfones, and polyether sulfones), a photoinitiator, and a polyol.

US-A-4,256,828 discloses a photocopolymerizable composition that comprises a first organic material having epoxide functionality greater than about 1.5, a second organic material having hydroxyl functionality of at least one, and a complex salt photoinitiator.

EP-A-276 716 discloses a curable epoxy composition comprising an epoxy resin, a sufficient amount of an ultraviolet catalyst to render the composition ultraviolet curable, and a sufficient amount of a fixing agent comprising poly(alkylene oxide) moieties to prevent immediate skinning upon ultraviolet exposure.

In general, this invention relates to epoxy/polyester hot melt compositions, especially those which cure on exposure to radiation to provide high strength adhesives having good green strength build-up. In one aspect of the invention, the hot melt compositions comprise from about 2 to 95 parts of an epoxy-containing material and, correspondingly, from about 98 to 5 parts of a polyester component. The compositions also include an effective amount of a photoinitiator for radiation curing the hot melt composition and an optional hydroxyl-containing material having a hydroxyl functionality greater than 2 wherein the hydroxyl-containing component is a polyether polyol. The hot melt compositions are solid at room temperature but can be melted to a liquid upon heating.

Preferably, the polyester component has a Brookfield viscosity which exceeds 10,000 milliPascals at 121°C with a number average molecular weight of about 7500 to 200,000, more preferably from about 10,000 to 50,000, and most preferably from about 15,000 to 30,000.

The optional hydroxyl-containing material more preferably has a hydroxyl functionality of about 3. Particularly preferred materials are polyoxyalkylene polyols such as polyoxyethylene glycols and polyoxypropylene glycols having a number average equivalent weight of about 31 to 2,250 and polyoxyethylene triols and polyoxypropylene triols having a number average equivalent weight of about 80 to 350. Also useful are polytetramethylene oxide glycols. The hydroxyl-containing material is useful in enhancing the flexibility of the hot melt compositions. In another aspect, the hydroxyl-containing material can sufficiently retard the curing reaction after the hot melt composition has been exposed to radiation so as to permit two substrates to be bonded together after the hot melt composition has been applied to only one of the substrates and irradiated.

In more preferred compositions according to the invention, the epoxy-containing material comprises from 2 to 80 parts thereof and the polyester component comprises, correspondingly, from 98 to 20 parts thereof. Even more preferred are hot melt compositions comprising from 2 to 60 parts of the epoxy-containing material and, correspondingly, from 98 to 40 parts of the polyester component.

The hot melt compositions of the invention can be provided as free standing, unsupported adhesive films which are particularly useful in laminating operations.

The compositions typically achieve a green strength build-up in 30 seconds or less, thereby permitting bonded components to be handled without the need for expensive, elaborate, cumbersome, clamping mechanisms. However, the compositions also cure to a high ultimate strength so that they may be used as structural adhesives.

The invention also relates to a method of adhesively bonding first and second substrates using the hot melt compositions of the invention. The hot melt composition is applied to one of the substrates and then exposed to radiation before the second substrate is adhesively bonded thereto. The methods of the invention can be practiced in conjunction with substrates which are not transparent to the radiation.

In general, this invention relates to a radiation curable hot-melt adhesive, coating and sealant composition that combines rapid green strength build-up with excellent ultimate strength and heat resistance. The ultimate strength is sufficiently great that the compositions of the invention can be used as structural adhesives, although they have many other uses. As used herein, a "hot melt composition" refers to a composition that is a solid at room temperature (about 20 to 22°C) but which, upon heating, melts to a viscous liquid that can be readily applied to a substrate. Desirably, the compositions of the invention can be formulated as solvent free systems (i.e., they have less than 1% solvent in the solid state).

The hot melt compositions of the invention comprise and, more preferably, consist essentially of, an epoxy-containing material that contributes to the ultimate strength and heat resistance of the composition, a polyester component that allows for rapid green strength build-up, a photoinitiator that permits the composition to cure (i.e., covalently crosslink) upon exposure to radiation and a hydroxyl-containing material having a hydroxyl functionality of at least 2, wherein the hydroxyl-containing component is a polyether polyol to retard the rate of curing and/or impart flexibility to the hot melt compositions.

Epoxy-containing materials useful in the compositions of the invention are any organic compounds having at least one oxirane ring 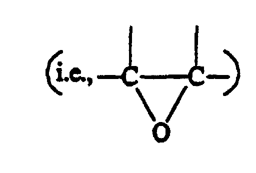 polymerizable by a ring opening reaction. Such materials, broadly called epoxides, include both monomeric and polymeric epoxides and can be aliphatic, cycloaliphatic, or aromatic. These materials generally have, on the average, at least two epoxy groups per molecule (preferably more than two epoxy groups per molecule). The polymeric epoxides include linear polymers having terminal epoxy groups (e.g., a diglycidyl ether of a polyoxyalkylene glycol), polymers having skeletal oxirane units (e.g., polybutadiene polyepoxide), and polymers having pendent epoxy groups (e.g., a glycidyl methacrylate polymer or copolymer). The molecular weight of the epoxy-containing material may vary from 58 to about 100,000 or more. Mixtures of various epoxy-containing materials can also be used in the hot melt compositions of the invention. The "average" number of epoxy groups per molecule is defined as the number of epoxy groups in the epoxy-containing material divided by the total number of epoxy molecules present.

Useful epoxy-containing materials include those which contain cyclohexene oxide groups such as the epoxycyclohexanecarboxylates, typified by 3,4-epoxycyclohexylmethyl-3,4-epoxycyclohexanecarboxylate, 3,4-epoxy-2-methylcyclohexylmethyl-3,4-epoxy-2-methycyclohexane carboxylate, and bis(3,4-epoxy-6-methylcyclohexylmethyl) adipate. For a more detailed list of useful epoxides of this nature, reference may be made to US-A-3,117,099.

Further epoxy-containing materials which are particularly useful in the practice of this invention include glycidyl ether monomers of the formula 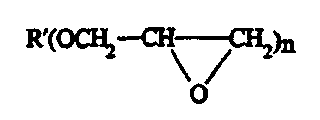 where R' is alkyl or aryl and n is an integer of 1 to 6. Examples are the glycidyl ethers of polyhydric phenols obtained by reacting a polyhydric phenol with an excess of chlorohydrin such as epichlorohydrin (e.g., the diglycidyl ether of 2,2-bis-(2,3-epoxypropoxyphenol) propane). Further examples of epoxides of this type which can be used in the practice of this invention are described in US-A-3,018,262.

There is a host of commercially available epoxy-containing materials which can be used in this invention. In particular, epoxides which are readily available include octadecylene oxide, epichlorohydrin, styrene oxide, vinyl cyclohexene oxide, glycidol, glycidylmethacrylate, diglycidyl ether of Bisphenol A (e.g., those available under the trade designations EPON 828, EPON 1004, and EPON 1001F from Shell Chemical Co., and DER-332 and DER-334, from Dow Chemical Co.), diglycidyl ether of Bisphenol F (e.g., ARALDITE GY281 from Ciba-Geigy), vinylcyclohexene dioxide (e.g., ERL 4206 from Union Carbide Corp.), 3,4-epoxycyclohexylmethyl-3,4-epoxycyclohexene carboxylate (e.g., ERL-4221 from Union Carbide Corp.), 2-(3,4-epoxycylohexyl-5,5-spiro-3,4-epoxy) cyclohexanemetadioxane (e.g., ERL-4234 from Union Carbide Corp.), bis(3,4-epoxycyclohexyl) adipate (e.g., ERL-4299 from Union Carbide Corp.), dipentene dioxide (e.g., ERL-4269 from Union Carbide Corp.), epoxidized polybutadiene (e.g., OXIRON 2001 from FMC Corp.), silicone resin containing epoxy functionality, epoxy silanes (e.g., beta-(3,4-epoxycyclohexyl)ethyltrimethoxy silane and gamma-glycidoxypropyltrimethoxy silane, commercially available from Union Carbide), flame retardant epoxy resins (e.g., DER-542, a brominated bisphenol type epoxy resin available from Dow Chemical Co.), 1,4-butanediol diglycidyl ether (e.g., ARALDITE RD-2 from Ciba-Geigy), hydrogenated bisphenol A-epichlorohydrin based epoxy resins (e.g. EPONEX 1510 from Shell Chemical Co.), and polyglycidyl ether of phenolformaldehyde novolak (e.g., DEN-431 and DEN-438 from Dow Chemical Co.).

Useful polyester components include both hydroxyl and carboxyl terminated materials, which may be amorphous or semicrystalline. Hydroxyl terminated materials are preferred. By "amorphous" is meant a material that displays a glass transition temperature but does not display a measurable crystalline melting point by differential scanning calorimetry (DSC). Preferably the glass transition temperature is less than the decomposition temperature of the photoinitiator (discussed below), but without being more than about 120°C. By "semicrystalline" is meant a polyester component that displays a crystalline melting point by DSC, preferably with a maximum melting point of about 150°C.

In general, if it is desired for the hot melt composition to cure under ambient conditions, the polyester component should a have glass transition temperature less than the ambient temperature, preferably less than about 20°C. As the glass transition temperature of the polyester component increases, it may be necessary to both thermally and radiation cure the composition.

The viscosity of the polyester component is important in providing a hot melt composition (as opposed to a composition which is a liquid having a measurable viscosity at room temperature). Accordingly, polyester components useful in the invention preferably have a Brookfield viscosity which exceeds 10,000 mPa at 121°C. Viscosity is related to the molecular weight of the polyester component. Preferred polyester components also have a number average molecular weight of about 7500 to 200,000, more preferably from about 10,000 to 50,000 and most preferably from about 15,000 to 30,000.

Polyester components useful in the invention comprise the reaction product of dicarboxylic acids (or their diester equivalents) and diols. The diacids (or their diester equivalents) can be saturated aliphatic i acids containing from 4 to 12 carbon atoms (including unbranched, branched, or cyclic materials having 5 to 6 atoms in a ring) and/or aromatic acids containing from 8 to 15 carbon atoms. Examples of suitable aliphatic acids are succinic, glutaric, adipic, pimelic, suberic, azelaic, sebacic, 1,12 dodecanedioic, 1,4-cyclohexanedicarboxylic, 1,3-cyclopentanedicarboxylic, 2-methylsuccinic, 2-methylpentanedioic, and 3-methylhexanedioic acids. Suitable aromatic acids include terephthalic acid, isophthalic acid, phthalic acid, 4,4'-benzophenone dicarboxylic acid, 4,4'-diphenylmethanedicarboxylic acid, 4,4'-diphenylether dicarboxylic acid, 4,4'-diphenylthioether dicarboxylic acid and 4,4'-diphenylamine dicarboxylic acid. Preferably the structure between the two carboxyl groups in these diacids contains only carbon and hydrogen; more preferably it is a phenylene group. Blends of any of the foregoing diacids may be used.

The diols include branched, unbranched, and cyclic aliphatic diols having from 2 to 12 carbon atoms, such as, for example, ethylene glycol, 1,3-propylene glycol, 1,2-propylene glycol, 1,4-butanediol, 1,3-butanediol, 1,5-pentanediol, 2-methyl-2,4-pentanediol, 1,6-hexanediol, 1,8-octanediol, cyclobutane-1,3-di(2'ethanol), cyclohexane-1,4-dimethanol, 1,10-decanediol, 1,12-dodecanediol, and neopentyl glycol. Long chain diols including poly(oxyalkylene) glycols in which the alkylene group contains from 2 to 9 carbon atoms (preferably 2 to 4 carbon atoms) may also be used. Blends of any of the foregoing diols may be used.

Useful, commercially available hydroxyl terminated polyester materials include various saturated, linear, semicrystalline copolyesters available from Hüls America, Inc. such as DYNAPOL S1402, DYNAPOL S1358, DYNAPOL S1227, DYNAPOL S1229 and DYNAPOL S1401. Useful saturated, linear amorphous copolyesters available from Hüls America, Inc. include DYNAPOL S1313 and DYNAPOL S1430.

The photoinitiators which are useful in the compositions of the invention are of three types, viz. aromatic iodonium complex salts, aromatic sulfonium complex salts and metallocene salts. Useful aromatic iodonium complex salts have the formula: 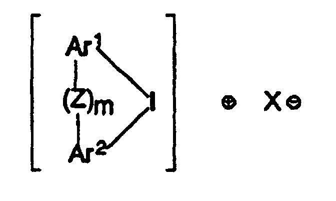 where Ar¹ and Ar² are aromatic groups having 4 to 20 carbon atoms and are selected from the group consisting of phenyl, thienyl, furanyl and pyrazolyl groups. Z is selected from the group consisting of oxygen; sulfur; 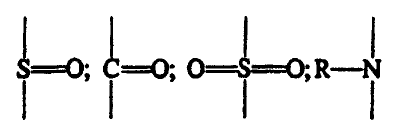 where R is aryl (of 6 to 20 carbons, such as phenyl) or acyl (of 2 to 20 carbons, such as acetyl, benzoyl, etc.); a carbon-to-carbon bond; or 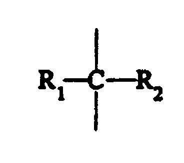 where R₁ and R₂ are selected from hydrogen, alkyl radicals of 1 to 4 carbons, and alkenyl radicals of 2 to 4 carbons. The value of m is zero or 1 and X is a halogen-containing complex anion selected from tetrafluoroborate, hexafluorophosphate, pentafluorohydroxyantimonate, hexafluoroarsenate, and hexafluoroantimonate.

The Ar¹ and Ar² aromatic groups may optionally have one or more fused benzo rings (e.g., naphthyl, benzothienyl, dibenzothienyl, benzofuranyl, dibenzofuranyl, etc.). The aromatic groups may also be substituted, if desired, by one or more non-basic groups if they are essentially non-reactive with epoxide and hydroxyl functionalities.

Useful aromatic iodonium complex salts are described more fully in US-A-4,256,828. The preferred aromatic iodonium complex salts are diaryliodonium hexafluorophosphate and diaryliodonium hexafluoroantimonate.

The aromatic iodonium complex salts useful in the compositions of the invention are photosensitive only in the ultraviolet region of the spectrum. They, however, can be sensitized to the near ultraviolet and the visible range of the spectrum by sensitizers for known photolyzable organic halogen compounds. Illustrative sensitizers include aromatic amines and colored aromatic polycyclic hydrocarbons.

Aromatic sulfonium complex salt photoinitiators suitable for use in the compositions of the invention can be defined by the formula 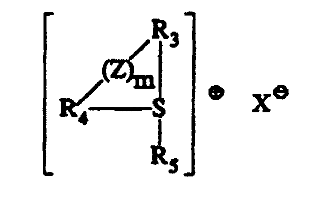 wherein R₃, R₄ and R₅ can be the same or different, provided that at least one of the groups is aromatic. These groups can be selected from aromatic moieties having 4 to 20 carbon atoms (e.g., substituted and unsubstituted phenyl, thienyl, and furanyl) and alkyl radicals having 1 to 20 carbon atoms. The term "alkyl" includes substituted alkyl radicals (for example, substituents such as halogen, hydroxy, alkoxy, aryl). Preferably, R₃, R₄ and R₅ are each aromatic. Z, m and X are all as defined above with regard to the iodonium complex salts.

If R₃, R₄ or R₅ is an aromatic group, it may optionally have one or more fused benzo rings (e.g, naphthyl, benzothienyl, dibenzothienyl, benzofuranyl, dibenzofuranyl, etc.) Such aromatic groups may also be substituted, if desired, by one or more non-basic groups that are essentially non-reactive with epoxide and hydroxyl functionality.

The triaryl-substituted salts such as triphenylsulfonium hexafluoroantimonate are preferred. Useful sulfonium complex salts are described more fully in US-A-4,256,828.

The aromatic sulfonium complex salts useful in the invention are inherently photosensitive only in the ultraviolet region of the spectrum. They, however, are sensitized to the near ultraviolet and the visible range of the spectrum by a select group of sensitizers such as described in US-A-4,256,828.

Useful metallocene salts can have the formula: 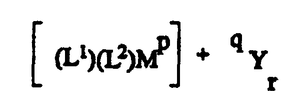 wherein
- M^{p}: represents a metal selected from Cr, Mo, W, Mn, Re, Fe, and Co;
- L¹: represents 1 or 2 ligands contributing π-electrons that can be the same or different ligand selected from substituted and unsubstituted η³-allyl, η⁵-cyclopentadienyl, and η⁷-cycloheptatrienyl and η⁶-aromatic compounds selected from η⁶-benzene and substituted η⁶-benzene compounds and compounds having 2 to 4 fused rings each capable of contributing 3 to 8 π-electrons to the valence shell of M^{p};
- L²: represents none or 1 to 3 ligands contributing an even number of sigma-electrons that can be the same or different ligand selected from carbon monoxide or nitrosonium;
with the proviso that the total electronic charge contributed to M^{p} by L¹ and L² plus the ionic charge on the metal M^{p} results in a net residual positive charge of q to the complex, and
- q: is an integer having a value of 1 or 2, the residual electrical charge of the complex cation;
- Y: is a halogen-containing complex anion selected from AsF₆-, SbF₆- and SbF₅OH-; and
- r: is an integer having a value of 1 or 2, the numbers of complex anions required to neutralize the charge q on the complex cation.

Useful metallocene salts are described more fully in US-A-5,089,536. The metallocene salts may be used in conjunction with a reaction accelerator such as an oxalate ester of a tertiary alcohol.

Useful commercially available photoinitiators include FX-512, an aromatic sulfonium complex salt (3M Company), an aromatic sulfonium complex salt (Union Carbide Corp.), UVI-6974, an aromatic sulfonium complex salt (Union Carbide Corp), and IRGACURE 261, a metallocene complex salt (Ciba-Geigy).

The hot melt compositions of the invention further comprise a hydroxyl-containing material having a hydroxyl functionality of at least 2, and most preferably about 3 wherein the hydroxyl-containing component is a polyether polyol. The number average equivalent weight of the hydroxyl-containing material is preferably about 31 to 2250, more preferably about 80 to 1000, and most preferably about 80 to 350.

Representative examples of useful polyether polyols include polyoxyalkylene polyols (e.g., polyoxyethylene and polyoxypropylene glycols and triols of equivalent weight of 31 to 2250 for the diols or 80 to 350 for triols) and polytetramethylene oxide glycols of varying molecular weight.

Useful commercially available hydroxyl-containing materials include the POLYMEG series (available from QO Chemicals, Inc.) of polytetramethylene oxide glycols such as POLYMEG 650, 1000 and 2000; the TERATHANE series (from E.I. duPont de Nemours and Company) of polytetramethylene oxide glycols such as TERATHANE 650, 1000 and 2000; POLYTHF, a polytetramethylene oxide glycol from BASF Corp.; VORANOL 230-238 (a glycerol polypropylene oxide adduct) from Dow Chemical Company; the SYNFAC series (from Milliken Chemical) of polyoxyalkylated bisphenol A's such as SYNFAC 8009, 773240, 8024, 8027, 8026, and 8031; and the ARCOL series (from Arco Chemical Co.) of polyoxypropylene polyols such as ARCOL 425, 1025, 2025, 42, 112, 168, and 240.

The amount of hydroxyl-containing organic material used in the compositions of the invention may vary over a broad range, depending on factors such as the compatibility of the hydroxyl-containing material with both the epoxy-containing material and the polyester component, the equivalent weight and functionality of the hydroxyl-containing material, and the physical properties desired in the final cured composition.

The hydroxyl-containing material is particularly useful in tailoring the flexibility of the hot melt compositions of the invention. As the equivalent weight of the hydroxyl-containing material increases, the flexibility of the hot melt composition correspondingly increases although there may be a consequent loss in cohesive strength. Similarly, decreasing equivalent weight may result in a loss of flexibility with a consequent increase in cohesive strength. Thus, the equivalent weight of the hydroxyl-containing material is selected so as to balance these two properties, the appropriate balance depending on the particular application.

Flexible hot melt compositions are useful in forming flexible adhesive films for manufacturing flexible laminates, flexible circuits and flexible hinges. On the other hand, a less flexible composition may be appropriate in bonding rigid substrates such as for laminating metal and ceramic materials. If the hydroxyl-containing material is used to tailor the flexibility of the hot melt composition, polyoxyethylene glycols and triols having an equivalent weight of about 31 to 2250 for the glycols and 80 to 350 for the triols are particularly preferred. Even more preferred are polyoxypropylene glycols and triols having an equivalent weight of about 31 to 2250 for the glycols and an equivalent weight of about 80 to 350 for the triols.

As explained more fully hereinbelow, the incorporation of polyether polyols into the hot melt compositions of the invention is especially desirable for adjusting the rate at which the compositions cure upon exposure to radiation. Increasing amounts of a polyether polyol can retard the curing reaction for a time sufficient to allow the bonding of substrates that are not radiation transparent. The effect is more pronounced when the polyester component has a glass transition temperature below about 20°C.

Useful polyether polyols (i.e., polyoxyalkylene polyols) for adjusting the rate of cure include polyoxyethylene and polyoxypropylene glycols and triols having an equivalent weight of about 31 to 2250 for the diols and about 80 to 350 for the triols, as well as polytetramethylene oxide glycols of varying molecular weight and polyoxyalkylated bisphenol A's.

The hot melt compositions of the invention comprise from 2 to 95 parts per 100 parts total of the epoxy-containing material and, correspondingly, from 98 to 5 parts of the polyester component. More preferably, the hot melt compositions of the invention comprise from 2 to 80 parts of the epoxy-containing material and, correspondingly, from 98 to 20 parts of the polyester component. Most preferably, the hot melt compositions of the invention comprise from 2 to 60 parts of the epoxy-containing material, and, correspondingly, from 98 to 40 parts of the polyester component. Increasing amounts of the epoxy-containing material relative to the polyester component generally result in hot melt compositions having higher ultimate strength and heat resistance but less flexibility, less green strength build-up, and lower viscosity. Increasing amounts of the polyester component generally result in hot melt compositions having lower ultimate strength, heat resistance and higher viscosity but greater flexibility and green strength build-up. Thus, the relative amounts of these two ingredients are balanced depending on the properties sought in the final composition.

The photoinitiator is included in an amount ranging from about 0.1 to 4% based on the combined weight of the epoxy-containing material and the polyester component. Increasing amounts of the photoinitiator result in an accelerated curing rate but require that the hot melt composition be applied in a thinner layer so as to avoid curing only at the surface. Increased amounts of photoinitiator can also result in reduced energy exposure requirements. The amount of the photoinitiator is determined by the rate at which the composition should cure, the intensity of the radiation source, and the thickness of the composition.

The relative amount of the optional hydroxyl-containing organic material is determined with reference to the ratio of the number of hydroxyl groups to the number of epoxy groups in the hot melt composition. That ratio may range from 0:1 to 1:1, more preferably from about 0.4:1 to 0.8:1. Larger amounts of the hydroxyl-containing material increase the flexibility of the hot melt composition but with a consequent loss of cohesive strength. If the hydroxyl containing material is a polyether polyol, increasing amounts will further slow the curing-process.

Additionally, and optionally, up to 50% of the total weight of the composition (based on the epoxy-containing material, the polyester component, the photoinitiator and the hydroxyl-containing material), may be provided by various fillers, adjuvants, additives and the like such as silica, glass, clay, talc, pigments, colorants, glass beads or bubbles, glass or ceramic fibers, antioxidants, and the like so as to reduce the weight or cost of the composition, adjust viscosity, and provide additional reinforcement. Fillers which are capable of absorbing the radiation used during the curing process should be used in an amount that does not adversely affect the curing process.

The hot melt compositions of the invention are prepared by mixing the various ingredients in a suitable vessel, preferably one that is not transparent to actinic radiation, at an elevated temperature sufficient to liquefy the components so that they can be efficiently mixed with stirring until the components are thoroughly melt blended but without thermally degrading the materials. The components may be added simultaneously or sequentially, although it is preferred to first blend the epoxy-containing material and the polyester component followed by the addition of the hydroxyl-containing material and then the photoinitiator.

The hot melt compositions should be compatible in the melt phase. That is, there should be no visible gross phase separation among the components. Compositions may be used directly after melt blending or may be packaged as a solvent free system in pails, drums, cartridges or other suitable containers, preferably in the absence of light, until ready for use. The compositions so packaged may be delivered to a hot-melt applicator system with the use of pail unloaders, cartridge dispensers, and the like. Alternatively, the hot melt compositions of the invention may be delivered to conventional bulk hot melt applicator and dispenser systems in the form of sticks, pellets, slugs, blocks, pillows or billets.

It is also possible to provide the hot melt compositions of the invention as uncured, unsupported rolls of adhesive film. Such films are useful in laminating operations. If the adhesive film is tacky, it is desirable to roll the film up with a release liner (for example, silicone-coated Kraft paper), with subsequent packaging in a bag or other container that is not transparent to actinic radiation.

The hot melt compositions of the invention may be applied to a wide variety of substrates by extruding, spraying, gravure printing, or coating, (e.g., by using a coating die, a heated knife blade coater, a roll coater or a reverse roll coater). Alternatively, the hot melt composition may be applied as an uncured adhesive film which, if necessary, can be die cut to a predefined shape. once applied, the hot melt composition may be tacky or tack-free, a blend of liquid and solid epoxy-containing materials being useful in achieving the former state. Substrates which can be coated or bonded include plastics, metals, ceramics, glass and cellulosic materials although primed, bare or painted metal substrates such as aluminum, cold rolled steel and porcelainized steel are particularly preferred.

Typically, the hot melt composition is applied to a single substrate by any of the methods described above, and once so applied is exposed to a radiation source to initiate the curing of the epoxy-containing material. The epoxy-containing material is believed to cure or crosslink with itself, the hydroxyl-containing material, and, perhaps, to some degree with the polyester component.

curing of the hot melt composition begins upon exposure of the composition to any source emitting actinic radiation (i.e., radiation having a wavelength in the ultraviolet or visible spectral regions) and continues for a period of time thereafter. Suitable sources of radiation include mercury, xenon, carbon arc, tungsten filament lamps and sunlight. Ultraviolet radiation, especially from a medium pressure mercury arc lamp, is most preferred. Exposure times may be from less than about 1 second to 10 minutes or more (to provide a total energy exposure of about 0.2 Joules/square centimeter (J/cm²)) depending upon both the amount and the type of reactants involved, the radiation source, the distance from the radiation source, and the thickness of the composition to be cured.

The compositions may also be cured by exposure to electron beam radiation. The dosage necessary is generally from less than 1 megarad to 100 megarads or more. The rate of curing tends to increase with increasing amounts of photoinitiator at a given light exposure or irradiation. The rate of curing also increases with increased radiation intensity or electron dosage.

Those hot melt compositions which include a polyether polyol that retards the curing rate are particularly desirable when bonding together two substrates that are not transparent to the radiation. After applying the hot melt composition to the first substrate and irradiating the composition, the second substrate may be bonded to the first substrate for a certain period of time (e.g., from about 2 minutes to about 4 hours) until the composition has sufficiently cured that a useful bond can no longer be made. Thus it will be recognized that the presence of the polyether polyol provides the hot melt compositions with an open time. That is, for a period of time (the open time) after the composition has been irradiated, it remains sufficiently uncured for a second substrate to be bonded thereto. (A similar effect may also be achieved through the use of a high glass transition temperature polyester component, e.g., a glass transition temperature above 20°C).

The second substrate is typically bonded using heat, pressure or both heat and pressure, (for example, with a heated press, heated nip rollers, or a heated laminator). Depending on the particular hot melt composition, the conditions for applying the second substrate may range from a few seconds at 177°C to about 15 seconds at room temperature. Typical exposures are for about 10 seconds at 138°C. Laminator pressures of about 274 kiloPascals (kPa) are useful. In another approach, a free standing film may be irradiated on one or both sides and then placed between two substrates followed by the use of heat, pressure or both heat and pressure to bond the film to the two substrates.

Alternatively, two substrates may be bonded together if one of the substrates is transparent to the radiation, thereby permitting the hot melt composition to be irradiated through the transparent substrate.

Once the hot melt composition is exposed to radiation, the curing process is initiated. Subsequent to radiation exposure the hot melt compositions can be tack-free, or can be tacky for a limited period of time but eventually achieving a tack-free condition. Full cure may be achieved under ambient conditions in about 24 hours or as little as about 8 to 16 hours, depending upon the intensity of the radiation source, the radiation exposure time, the concentration of the photoinitiator, and the particular ingredients which comprise the hot melt composition. When curing under only ambient conditions is desired, the glass transition temperature of the polyester component should be less than the ambient temperature, preferably less than about 20°C.

The time to reach full cure may be accelerated by post curing the compositions with heat, such as in an oven. The time and temperature of the post cure will vary depending upon the glass transition temperature of the polyester component, the concentration of the photoinitiator and the radiation exposure conditions. Typical post cure conditions range from 5 to 15 minutes at about 50°C to about 1 to 2 minutes at temperatures up to about 100°C. An accelerated cure can also be achieved by applying heat and pressure to bond two substrates together such as when using a heated press, a heated laminator or heated nip rollers. For those hot melt compositions based on a polyester component having a glass transition temperature above about 20°C, the use of heat in addition to radiation to cure the composition is recommended.

### General Preparation and Test Procedures

The following general procedure was used in preparing the hot melt compositions described more fully below in the various examples. In each case, the components of the hot melt composition were blended at 110°C for approximately one hour in a suitable vessel. Once so mixed, the hot melt composition was coated at a thickness of about 254 microns onto a silicone-treated Kraft paper release liner using a knife bar coater heated to 127°C so as to provide an uncured, unsupported adhesive film. The various compositions were then tested to evaluate properties such as overlap shear strength, green strength build-up, and heat resistance. In each example, the hot melt composition bonded together two 0.16 cm thick 2024T3 alclad aluminum substrates that had been FPL-etched with a mixture of chromic acid and sulfuric acid.

Bonded samples for testing were prepared by placing the exposed face of the adhesive film against one of the aluminum substrates. The film was bonded to the substrate with heat and pressure (71°C and 345 kPa for 5 seconds). The release liner was then removed and the newly exposed face of the adhesive film was subjected to the radiation output of a 79 watts/cm medium pressure mercury arc lamp (12HD from UV Process Supply, Inc., Chicago, Illinois) situated 15 cm from a web moving at a speed of 31.8 cm/minute so as to provide a total energy exposure of 0.20 J/cm² to activate the hot melt composition. After about five minutes, the second substrate was bonded to the adhesive using a heated press (276 kPa at 126°C for 30 seconds to ensure cohesive failure for the overlap shear strength test; 276 kPa at 93°C for 30 seconds for the green strength build-up and heat resistance tests). The size of the bonded area is described more fully below with respect to the specific test.

Samples used in the overlap shear strength and heat resistance tests were post cured for 48 hours under ambient conditions (22-26°C) before testing. For the green strength build-up test, the bonded substrates were evaluated within 30 seconds after having been removed from the heated press.

### 1. overlap Shear Strength.

The two aluminum substrates were bonded with a 2.54 cm x 1.27 cm overlap area and then tested at room temperature in a SINTECH tensile testing machine using a crosshead speed of 2.5 mm per minute. The reported data are an average of 3 measurements. Preferably, the hot melt compositions display an overlap shear strength of at least 4000 kPa.

### 2. Green Strength Build-Up.

Bonded samples were prepared using a 2.54 cm x 2.54 cm overlap area. A free end of one substrate was held in a clamp while a 0.45 kilogram (kg) mass was suspended from the free end of the second substrate, this test arrangement being prepared within 30 seconds of having removed the bonded substrates from the heated press. Over a period of 24 hours the distance that the second substrate moved was measured. The bond failed if the second substrate moved at least 2.54 cm. Preferably, the movement was less than 0.76 cm, more preferably 0 cm. Reported data are an average of 3 measurements.

Compositions which resulted in substrate movement of 0.76 cm or less were regarded as having excellent green strength build-up because they had reached a handling strength within 30 seconds of the bond having been made, thereby eliminating the need for cumbersome clamping mechanisms to otherwise secure the bonded components until the adhesive had cured sufficiently to permit the parts to be handled. Green strength build-up in 20 seconds or less is possible.

### 3. Heat Resistance.

A bonded sample having a 2.54 cm x 2.54 cm overlap was prepared and placed in a 93°C oven. The free end of one of the substrates was held in a clamp while a 0.91 kg mass was suspended from the free end of the second substrate. After every 30 minute interval, the temperature was increased 11°C in a step function until the oven temperature reached 216°C or the bond failed. The reported data are an average of 3 measurements and represents the temperature at which the bond failed (if it failed). Preferably, the heat resistance is greater than 149°C.

The invention will be more fully appreciated with reference to the following nonlimiting examples in which parts refer to parts by weight.

### Examples 1 to 10

Examples 1 to 10 were prepared according to the general procedure described above. The epoxy-containing material was EPON 1001F, a diglycidylether of bisphenol A commercially available from Shell Chemical Company. The polyester component was DYNAPOL S1358, a saturated linear copolyester commercially available from Hüls America, Inc. The hydroxyl-containing material was VORANOL 230-238, a glycerol polypropylene oxide adduct commercially available from Dow Chemical Company. The ingredients were blended in the amounts (parts) shown in Table 1 below. Each example further included 1 part of a triphenyl sulfonium hexafluoroantimonate photoinitiator prepared as described in U.S. Pat. No. 4,321,951 (column 5, line 48 to column 7, line 48). The hydroxyl group to epoxy group ratio of each example was 0.77:1 (except for example 10 where it was 0). The examples were tested for overlap shear strength, green strength build-up, and heat resistance, with the results shown below in Table 1.

**TABLE 1**

| | Example | | | | | | | | | |
|---|---|---|---|---|---|---|---|---|---|---|
| | comparative example 1 | 2 | 3 | 4 | 5 | 6 | 7 | 8 | 9 | comparative example10 |
| Epoxy-Containing Material | 74.0 | 67.2 | 59.7 | 52.2 | 44.0 | 34.0 | 24.0 | 14.0 | 4.0 | 0.0 |
| Polyester Component | 0.0 | 10.0 | 20.0 | 30.0 | 40.0 | 53.5 | 66.8 | 80.2 | 93.6 | 99. 0 |
| Hydroxyl-Containing Material | 25.0 | 22.8 | 20.3 | 17.8 | 15.0 | 11.5 | 8.2 | 4.8 | 1.4 | 0.0 |
| Overlap Shear Strength (kPa) | 11,515 | 7012 | 9998 | 7033 | 6661 | 6881 | 6709 | 7157 | 6019 | 2613 |
| Green Strength (cm) | 1.35 | 0.74 | 0.58 | 0.28 | 0 | 0 | 0 | 0 | 0 | 0 |
| Heat Resistance (°C) | >215 | >215 | >215 | >215 | >215 | >215 | 154 | 104 | <93 | <93 |

The data of Table 1 show the beneficial effect on green strength build-up which results from increasing proportions of the polyester component, up to about 45 to 50 parts. Increasing amounts of the epoxy-containing material give generally steady improvements in overlap shear strength and heat resistance.

### Examples 11 to 19

Examples 11 to 19 were prepared according to the procedure of examples 1 to 10 except that the DYNAPOL S1358 was replaced by DYNAPOL S1402, a saturated linear copolyester from Hüls America, Table 2 below showing the relative amounts of each material along with the results from the green strength build-up and heat resistance tests. The hydroxyl group to epoxy group ratio was 0 in example 19 but was 0.77:1 for examples 11 to 18.

**TABLE 2**

| | Example | | | | | | | | |
|---|---|---|---|---|---|---|---|---|---|
| | 11 | 12 | 13 | 14 | 15 | 16 | 17 | 18 | comparative example 19 |
| Epoxy-Containing Material | 67.2 | 59.7 | 52.2 | 44.0 | 34.0 | 24.0 | 14.0 | 4.0 | 0.0 |
| Polyester Component | 10.0 | 20.0 | 30.0 | 40.0 | 53.5 | 66.8 | 80.2 | 93.6 | 99. 0 |
| Hydroxyl-Containing Material | 22.8 | 20.3 | 17.8 | 15.0 | 11.5 | 8.2 | 4.8 | 1.4 | 0.0 |
| Green Strength (cm) | 1.12 | 0.56 | 0.56 | 0.05 | 0 | 0 | 0 | 0 | 0 |
| Heat Resistance (°C) | >215 | >215 | >215 | >215 | >215 | 177 | <93 | <93 | <93 |

The data of Table 2 show that increasing amounts of the polyester component improve green strength build-up while increasing amounts of the epoxy-containing material improve heat resistance.

### Examples 20 and 21

Examples 20 and 21 were prepared according to the procedure of examples 1 to 10 with the relative amounts of each of the ingredients being as shown in Table 3 below. Also reported in Table 3 are examples 6 and 10 along with the results of the green strength build-up and heat resistance tests.

**TABLE 3**

| | Example | | | |
|---|---|---|---|---|
| | comparative example 10 | 20 | 6 | 21 |
| Epoxy-Containing Material | 0.0 | 38.5 | 34.0 | 32.3 |
| Polyester Component | 99.0 | 53.5 | 53.5 | 53.5 |
| Hydroxyl-Containing Material | 0.0 | 7.0 | 11.5 | 14.1 |
| Hydroxyl Group to Epoxy Group Ratio | 0:1 | 0.4:1 | 0.77:1 | 0.98:1 |
| Green Strength (cm) | 0.0 | 0.0 | 0.0 | 0.0 |
| Heat Resistance (°C) | <93 | >215 | >215 | 154 |

The data of Table 3 show that the green strength build-up is relatively unaffected by varying the epoxy group to hydroxyl group ratio. The green strength build-up is primarily attributable to the presence of the polyester component. The heat resistance is provided principally by the epoxy-containing material.

The compositions of the invention provide a unique balance of highly desirable properties. As solvent free compositions, they are easily applied using conventional hot melt dispensing systems. Unlike moisture curing hot melt adhesives and coatings; the hot melt compositions of the invention are not moisture sensitive. Consequently, they can be supplied as adhesive films well suited for laminating operations. The painstaking exclusion of moisture during manufacturing and packaging, which is a facet of using moisture curing hot melt compositions, is not of concern when using the compositions of the invention.

The hot melt compositions of the invention display excellent green strength build-up. Within 30 seconds or less of a bond having been made, the bonded components can be handled, thereby eliminating the need for elaborate, expensive, cumbersome clamping mechanisms often required with thermally cured hot melts and epoxy based adhesives. However, the compositions of the invention also quickly cure to full strength to provide structural adhesives. Full cure can be achieved in 24 hours or less under ambient conditions or even more quickly if thermally postcured.

The inclusion of a polyether polyol of appropriate molecular weight and functionality provides the compositions of the invention with an open time. (A similar affect can be achieved by using a high glass transition temperature polyester.) That is, after the composition is exposed to radiation to initiate the curing process, a second substrate may be bonded thereto for a certain period of time (until the composition cures to a degree that does not permit a bond to be made). In the absence of an open time, the compositions are best used to hot melt coat a single substrate or to bond two substrates together if one is transparent to the radiation source.

The one part systems of the invention are readily handled and require no storage or mixing of separate components as do so-called two part adhesives. Because the compositions of the invention only cure upon exposure to actinic or electron beam radiation, the compositions have a virtually unlimited pot life. This also permits the compositions to be provided as die-cuttable adhesive films for laminating operations.

With these properties, the hot melt compositions are particularly well suited for high performance laminates such as bonding metal sheets or skins to each other or to structural honeycombs such as might be found in airplane interiors, curtain walls, and modular interior partitions.

Because of the ability to tailor the flexibility of the compositions of the invention by incorporating a hydroxyl-containing material therein the compositions are also useful in certain electronic industry applications such as tape automated bonding (TAB) and flexible circuit bonding. The flexibility of the compositions of the invention also make them suitable for coating or sealing coated abrasive article backings made of natural or synthetic fibers or other materials.

The hot melt compositions of the invention also have utility as vibration damping materials for damping resonant vibrations of articles to which they are attached. The compositions may be used as either a free layer or in conjunction with a relatively stiff metal or polymeric constraining layer.

The hot melt compositions may also be used as sealants, for example as an automotive body panel sealer.

## Claims

1. A hot melt composition comprising:
(a) from about 2 to 95 parts of an epoxy-containing material;
(b) correspondingly, from about 98 to 5 parts of a polyester component, wherein the sum of (a) + (b) equals 100 parts;
(c) an effective amount of a photoinitiator for radiation curing the hot melt composition; and
(d) an hydroxyl-containing material having a hydroxyl functionality of at least 2, wherein the hydroxyl-containing component is a polyether polyol;
wherein the hot melt composition is a solid at room temperature that can be melted to a liquid upon heating.

2. A hot melt composition according to claim 1 wherein the polyester component has a number average molecular weight of about 15,000 to 200,000.

3. A hot melt composition according to claim 2 wherein the polyester component has a number average molecular weight of about 15,000 to 30,000.

4. A hot melt composition according to claim 1 wherein the polyester component is hydroxyl or carboxyl terminated and has a crystalline melting point measured by differential scanning calorimetry with a maximum melting point of about 150°C.

5. A hot melt composition according to any one of claims 1 to 4 wherein the composition remains sufficiently uncured for up to 4 hours after exposure to an effective amount of radiation to initiate the photoinitiator such that a substrate can be bonded thereto.

6. A hot melt composition according to any one of claims 1 to 5 wherein the polyether polyol is selected from the group consisting of polyoxyethylene glycols, polyoxyethylene triols, polyoxypropylene glycols, and polyoxypropylene triols.

7. A hot melt composition according to any one of claims 1 to 6 wherein the ratio of the number of hydroxyl groups to the number of epoxy groups in the hot melt composition is from 0.4:1 to 0.8:1.

8. A hot melt composition according to any one of claims 1 to 7 wherein the polyester component is the reaction product of (a) a dicarboxylic acid selected from the group consisting of saturated aliphatic dicarboxylic acids containing from 4 to 12 carbon atoms (and diester derivatives thereof) and aromatic dicarboxylic acids containing from 8 to 15 carbon atoms (and diester derivatives thereof) and (b) a diol having 2 to 12 carbon atoms.

9. A hot melt composition according to any one of claims 1 to 8 wherein the hot melt composition comprises from 2 to 80 parts of the epoxy-containing material and, correspondingly, from 98 to 20 parts of the polyester component.

10. A hot melt composition according to any one of claims 1 to 9 wherein the hot melt composition comprises from 2 to 60 parts of the epoxy-containing material and, correspondingly, from 98 to 40 parts of the polyester component.

11. A hot melt composition according to any one of claims 1 to 10 wherein the polyester component is hydroxyl terminated.

12. A hot melt composition according to any one of claims 1 to 11 wherein the hot melt composition results in substrate movement of 0.76 cm or less in the green strength build-up test consisting of the following steps:
(i) prepare bonded samples having a 2.54 cm x 2.54 cm overlap area;
(ii) hold the free end of one substrate in a clamp while a 0.45 kg mass is suspended from the free end of the second substrate, this test arrangement being prepared within 30 seconds from bonding;
(iii) measure the distance that the second substrate moved over a period of 24 hours; and
(iv) calculate the substrate movement as the average of three measurements.

13. A hot melt composition according to any one of claims 1 to 12 wherein the hot melt composition may be provided as an uncured, free-standing, unsupported adhesive film.

14. An article comprising a first substrate having a layer of a hot melt composition according to any preceding claim adhesively bonded thereto.

15. A method of bonding first and second substrates together comprising the steps of:
(a) applying a hot melt composition according to any one of claims 1 to 13 to the first substrate;
(b) exposing the hot melt composition to radiation to initiate curing; and
(c) bonding the second substrate to the first substrate using the hot melt composition during a period of time that the hot melt composition remains sufficiently uncured such that a second substrate can be bonded thereto.

16. The method of claim 15 wherein the period of time that the hot melt composition remains sufficiently uncured is up to 4 hours after exposing the hot melt composition to radiation.

17. The method of claim 15 wherein the hot melt composition is applied to the first substrate in the molten state.

18. A method of bonding first and second substrates together comprising the steps of:
(a) providing the hot melt composition according to any one of claims 1 to 13 in the form of a free-standing film;
(b) irradiating the film on one or both sides;
(c) placing the irradiated film between two substrates; and
(d) applying heat, pressure or both heat and pressure to bond the film to the two substrates.

## Patentansprüche

1. Schmelzzusammensetzung, umfassend:
(a) etwa 2 bis 95 Teile eines Epoxygruppen enthaltenden Materials;
(b) entsprechend, etwa 98 bis 5 Teile einer Polyesterkomponente, wobei die Summe von (a) + (b) gleich 100 Teilen ist;
(c) eine wirksame Menge eines Photoinitiators zur Strahlungshärtung der Schmelzzusammensetzung; und
(d) ein Hydroxygruppen enthaltendes Material, welches eine Hydroxyfunktionalität von mindestens 2 aufweist, wobei die Hydroxygruppen enthaltende Komponente ein Polyetherpolyol ist;
wobei die Schmelzzusammensetzung bei Raumtemperatur ein Feststoff ist, welcher durch Erwärmen zu einer Flüssigkeit geschmolzen werden kann.

2. Schmelzzusammensetzung gemäß Anspruch 1, wobei die Polyesterkomponente ein Zahlenmittel des Molekulargewichts von etwa 15000 bis 200000 aufweist.

3. Schmelzzusammensetzung gemäß Anspruch 2, wobei die Polyesterkomponente ein Zahlenmittel des Molekulargewichts von etwa 15000 bis 30000 aufweist.

4. Schmelzzusammensetzung gemäß Anspruch 1, wobei die Polyesterkomponente eine Hydroxy- oder Carboxyendgruppe aufweist und einen kristallinen Schmelzpunkt, welcher durch Differentialscanningkalorimetrie gemessen wird, mit einem maximalen Schmelzpunkt von etwa 150 °C aufweist.

5. Schmelzzusammensetzung gemäß einem der Ansprüche 1 bis 4, wobei die Zusammensetzung, nachdem sie Strahlung in einer Menge ausgesetzt wurde, die wirksam ist, um den Photoinitiator zu initiieren, bis zu 4 Stunden ausreichend nichtgehärtet bleibt, so dass ein Substrat daran gebunden werden kann.

6. Schmelzzusammensetzung gemäß einem der Ansprüche 1 bis 5, wobei das Polyetherpolyol aus Polyoxyethylenglycolen, Polyoxyethylentriolen, Polyoxypropylenglycolen und Polyoxypropylentriolen ausgewählt ist.

7. Schmelzzusammensetzung gemäß einem der Ansprüche 1 bis 6, wobei das Verhältnis der Anzahl der Hydroxygruppen zu der Anzahl der Epoxygruppen in der heißschmelzbaren Zusammensetzung von 0,4 : 1 bis 0,8 : 1 ist.

8. Schmelzzusammensetzung gemäß einem der Ansprüche 1 bis 7, wobei die Polyesterkomponente das Reaktionsprodukt (a) einer Dicarbonsäure, ausgewählt aus gesättigten, aliphatischen, 4 bis 12 Kohlenstoffatome enthaltenden Dicarbonsäuren (und Diesterderivaten davon) und aromatischen, 8 bis 15 Kohlenstoffatome enthaltenden Dicarbonsäuren (und Diesterderivaten davon), und (b) eines 2 bis 12 Kohlenstoffatome aufweisenden Diols ist.

9. Schmelzzusammensetzung gemäß einem der Ansprüche 1 bis 8, wobei die Schmelzzusammensetzung 2 bis 80 Teile des Epoxygruppen enthaltenden Materials und, entsprechend, 98 bis 20 Teile der Polyesterkomponente umfasst.

10. Schmelzzusammensetzung gemäß einem der Ansprüche 1 bis 9, wobei die Schmelzzusammensetzung 2 bis 60 Teile des Epoxygruppen enthaltenden Materials und, entsprechend, 98 bis 40 Teile der Polyesterkomponente umfasst.

11. Schmelzzusammensetzung gemäß einem der Ansprüche 1 bis 10, wobei die Polyesterkomponente eine Hydroxyendgruppe aufweist.

12. Schmelzzusammensetzung gemäß einem der Ansprüche 1 bis 11, wobei die Schmelzzusammensetzung in dem Test zur Bestimmung der Einstellzeit der Grünfestigkeit eine Substratbewegung von 0,76 cm oder weniger aufweist, wobei der Test aus den nachfolgenden Schritten besteht:
(i) Herstellen von verbundenen Proben, welche eine überlappende Fläche von 2,54 cm × 2,54 cm aufweisen;
(ii) Halten des freien Endes eines Substrats in einer Klammer, während ein Gewicht von 0,45 kg von dem freien Ende des zweiten Substrats herabhängt, wobei diese Versuchsanordnung innerhalb von 30 Sekunden ab dem Verbinden erstellt wird;
(iii) Messen der Entfernung, welche das zweite Substrat über eine Zeitdauer von 24 Stunden zurückgelegt hat; und
(iv) Berechnen der Substratbewegung als den Durchschnittswert von drei Messungen.

13. Schmelzzusammensetzung gemäß einem der Ansprüche 1 bis 12, wobei die Schmelzzusammensetzung als eine nichtgehärtete, selbsttragende Klebstofffolie ohne Träger bereitgestellt werden kann.

14. Gegenstand, umfassend ein erstes Substrat, an dem eine Schicht einer Schmelzzusammensetzung gemäß einem der vorstehenden Ansprüche gebunden ist.

15. Verfahren zum Verbinden eines ersten und eines zweiten Substrats, umfassend die Schritte:
(a) Aufbringen einer Schmelzzusammensetzung gemäß einem der Ansprüche 1 bis 13 auf das erste Substrat;
(b) Bestrahlen der Schmelzzusammensetzung, um Härtung zu initiieren; und
(c) Binden des zweiten Substrats an das erste Substrat unter Verwendung der Schmelzzusammensetzung innerhalb einer Zeitdauer, in welcher die Schmelzzusammensetzung ausreichend nichtgehärtet bleibt, so dass ein zweites Substrat damit verbunden werden kann.

16. Verfahren gemäß Anspruch 15, wobei die Zeitdauer, in welcher die Schmelzzusammensetzung ausreichend nichtgehärtet bleibt, bis zu 4 Stunden nach Bestrahlen der Schmelzzusammensetzung ist.

17. Verfahren gemäß Anspruch 15, wobei die Schmelzzusammensetzung im geschmolzenen Zustand auf das erste Substrat aufgebracht wird.

18. Verfahren zum Verbinden eines ersten und eines zweiten Substrats, umfassend die Schritte:
(a) Bereitstellen der Schmelzzusammensetzung gemäß einem der Ansprüche 1 bis 13 in der Form einer selbsttragenden Folie;
(b) Bestrahlen der Folie auf einer Seite oder auf beiden Seiten;
(c) Plazieren der bestrahlten Folie zwischen zwei Substrate; und
(d) Anwenden von Wärme, Druck oder sowohl Wärme als auch Druck, um die Folie an die zwei Substrate zu binden.

## Revendications

1. Composition thermofusible comprenant :
(a) d'environ 2 à 95 parties d'une substance contenant des groupes époxy ;
(b) respectivement, d'environ 98 à 5 parties d'un composant polyester, dans laquelle la somme (a) + (b) est égale à 100 parties ;
(c) une quantité efficace d'un photoamorceur pour durcir par rayonnement la composition thermofusible ; et
(d) une substance contenant un hydroxyle ayant une fonctionnalité d'hydroxyle d'au moins 2, dans laquelle le composant contenant l'hydroxyle est un polyéther polyol ;
dans laquelle la composition thermofusible est un solide à température ambiante qui peut être fondu jusqu'à l'état liquide lors du chauffage.

2. Composition thermofusible selon la revendication 1, dans laquelle le composant polyester a une masse moléculaire moyenne en nombre d'environ 15000 à 200000.

3. Composition thermofusible selon la revendication 2, dans laquelle le composant polyester a une masse moléculaire moyenne en nombre d'environ 15000 à 30000.

4. Composition thermofusible selon la revendication 1, dans laquelle le composant polyester est terminé par un groupe hydroxyle ou carboxyle et a un point de fusion cristallin mesuré par calorimétrie différentielle à balayage avec un point de fusion maximum d'environ 150°C.

5. Composition thermofusible selon l'une quelconque des revendications 1 à 4, dans laquelle la composition reste suffisamment non traitée jusqu'à 4h après exposition à une quantité efficace de rayonnement pour amorcer le photoamorceur afin qu'un substrat puisse s'y lier.

6. Composition thermofusible selon l'une quelconque des revendications 1 à 5, dans laquelle le polyéther polyol est choisi dans le groupe constitué par des polyoxyéthylène glycols, polyoxyéthylène triols, polyoxypropylène glycols et polyoxypropylène triols.

7. Composition thermofusible selon l'une quelconque des revendications 1 à 6, dans laquelle le rapport du nombre de groupes hydroxyle sur le nombre de groupes époxy dans la composition thermofusible est de 0,4:1 à 0,8:1.

8. Composition thermofusible selon l'une quelconque des revendications 1 à 7, dans laquelle le composant polyester est le produit réactionnel (a) d'un acide dicarboxylique choisi dans le groupe constitué d'acides dicarboxyliques aliphatiques saturés contenant de 4 à 12 atomes de carbone (et leurs dérivés diester) et d'acides dicarboxyliques aromatiques contenant de 8 à 15 atomes de carbone (et leurs dérivés diester) et (b) d'un diol ayant 2 à 12 atomes de carbone.

9. Composition thermofusible selon l'une quelconque des revendications 1 à 8, dans laquelle la composition thermofusible comprend de 2 à 80 parties de la substance contenant des groupes époxy et, de manière correspondante, de 98 à 20 parties du composant polyester.

10. Composition thermofusible selon l'une quelconque des revendications 1 à 9, dans laquelle la composition thermofusible comprend de 2 à 60 parties de la substance contenant des groupes époxy et, de manière correspondante, de 98 à 40 parties du composant polyester.

11. Composition thermofusible selon l'une quelconque des revendications 1 à 10, dans laquelle le composant polyester est terminé par un groupe hydroxyle.

12. Composition thermofusible selon l'une quelconque des revendications 1 à 11, dans laquelle la composition thermofusible résulte en un déplacement du substrat de 0,76 cm ou moins dans le test pour la détermination du temps necessaire pour la mise au point de la resistance à vert se composant des étapes suivantes :
(i) préparer des échantillons liés ayant une surface de recouvrement de 2,54 cm x 2,54 cm ;
(ii) tenir l'extrémité libre d'un substrat dans une pince pendant qu'une masse de 0,45 kg est suspendue à partir de l'extrémité libre du second substrat, cette manipulation test étant préparée dans les 30 secondes à partir de la liaison ;
(iii) mesurer la distance parcourue par le second substrat sur une période de 24h ; et
(iv) calculer le déplacement du substrat comme une moyenne de trois mesures.

13. Composition thermofusible selon l'une quelconque des revendications 1 à 12, dans laquelle la composition thermofusible peut être fourni en tant que film adhésif non durci, autoportant et libre de tout support.

14. Article comprenant un premier substrat ayant une couche d'une composition thermofusible selon l'une quelconque des revendications précédentes liée de manière adhésive à ce dernier.

15. Procédé pour lier un premier et un second substrat ensemble comprenant les étapes d' :
(a) application d'une composition thermofusible selon l'une quelconque des revendications 1 à 13 au premier substrat ;
(b) exposition de la composition thermofusible au rayonnement pour initier le durcissement ; et
(c) liaison du second substrat au premier substrat en utilisant la composition thermofusible pendant une durée telle que la composition thermofusible reste suffisamment non durcie pour qu'un second substrat puisse s'y lier.

16. Procédé selon la revendication 15, dans lequel la durée pendant laquelle la composition thermofusible reste suffisamment non durcie s'élève jusqu'à 4 heures après exposition de la composition thermofusible au rayonnement.

17. Procédé selon la revendication 15, dans lequel la composition thermofusible est appliquée au premier substrat à l'état fondu.

18. Procédé pour lier un premier et un second substrat ensemble comprenant les étapes de :
(a) apport de la composition thermofusible selon l'une quelconque des revendications 1 à 13 sous forme de film libre de tout support ;
(b) irradiation du film sur une face ou les deux ;
(c) mise en place du film irradié entre deux substrats ; et
(d) application de chaleur, de pression, ou à la fois de chaleur et de pression ensemble afin de lier le film aux deux substrats.
